Europäisches Patentamt

European Patent Office

Office européen des brevets

(19)

(11) Numéro de publication: **0 349 042**
**A2**

(12) **DEMANDE DE BREVET EUROPEEN**

(21) Numéro de dépôt: 89201597.5

(22) Date de dépôt: **19.06.89**

(51) Int. Cl.⁴: **G01R 31/28**

(30) Priorité: **24.06.88 FR 8808502**

(43) Date de publication de la demande:
**03.01.90 Bulletin 90/01**

(84) Etats contractants désignés:
**DE FR GB IT NL**

(71) Demandeur: **LABORATOIRES D'ELECTRONIQUE ET DE PHYSIQUE APPLIQUEE L.E.P.**
**3, Avenue Descartes**
**F-94450 Limeil-Brévannes(FR)**
(84) **FR**

Demandeur: **N.V. Philips' Gloeilampenfabrieken**
**Groenewoudseweg 1**
**NL-5621 BA Eindhoven(NL)**
(84) **DE GB IT NL**

(72) Inventeur: **Binet, Michel Société Civile S.P.I.D.**
**209, rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Système de contrôle automatique de circuits intégrés.**

(57) Système de contrôle automatique de circuits intégrés dans lequel la tranche de circuit intégré (10) à tester est supportée par un porte-échantillon (61) et reliée électriquement à une carte à pointes (60). Ce système comprend (a) une chambre (20) traversée par un flux de gaz sec et en surpression ; (b) un ensemble mécanique (40) de tables (41, 42, 43, 44) de commande des déplacements de la tranche à tester, avec interpolation d'une cale (46) thermiquement isolante entre ledit ensemble de tables et le porte-échantillon (61) ; (c) un dispositif (80) de refroidissement de porte-échantillon (61) interne au système et comprenant lui-même un réservoir (81) de fluide réfrigérant, un tube (83) se prolongeant dans ledit fluide pour conduire celui-ci vers une cavité (63) de refroidissement interne au porte-échantillon, et un dispositif (64, 65) d'évacuation du fluide gazeux apparu dans ladite cavité.
Application : tests de matériaux supraconducteurs

FIG. 1

## Système de contrôle automatique de circuits intégrés

La présente invention concerne un système de contrôle automatique de circuits intégrés en tranche comprenant :

(a) une chambre équipée d'au moins un orifice d'admission pour l'introduction d'un gaz sec inerte et d'au moins un orifice d'évacuation, des dispositifs d'une part de séchage et chauffage et d'autre part de contrôle de la surpression dans la chambre étant éventuellement adjoints auxdits orifices d'admission et d'évacuation respectivement ;

(b) dans ladite chambre, un porte-échantillon de support desdits circuits intégrés ;

(c) un ensemble mécanique pour la commande des déplacements relatifs du porte-échantillon et d'une carte de test des circuits intégrés. Ce système est utilisable notamment pour le contrôle de matériaux supraconducteurs.

On sait depuis plusieurs décennies comment annuler ou réduire considérablement la résistance électrique d'un conducteur en le refroidissant très fortement. Les qualités des matériaux dits supraconducteurs ainsi obtenus ouvrent des perspectives variées et, notamment, ont permis d'envisager la mise au point de circuits électroniques sans pertes de chaleur et donc très petits et très rapides, et même de circuits intégrés.

Ces circuits intégrés ne peuvent cependant être utilisés industriellement que si l'on dispose des moyens d'en contrôler la qualité. Les tests de circuits intégrés sont, à l'heure actuelle, réalisés soit à la température ambiante, soit à des températures supérieures, à l'aide de machines de contrôle à déplacement automatique permettant de tester les millions de composants d'une même tranche de circuit intégré sans intervention d'un opérateur. Par contre, il n'existe pas de système vraiment satisfaisant permettant de réaliser de tels tests à basse température. En effet, si l'on refroidit la tranche de circuit intégré, l'humidité de l'air se condense et se dépose sur ladite tranche sous forme d'eau ou de glace, ce qui interdit les mesures. Ces mesures à basse température ne pourraient être envisagées que sur des circuits intégrés découpés et montés en boîtier, et placés dans un cryostat où le vide a été réalisé pour enlever toute trace d'humidité. Ce processus donne satisfaction, mais ne permet que des tests unitaires ou portant tout au plus sur quelques dispositifs, à l'opposé des tests automatisés cités précédemment et qui concernent tous les dispositifs d'une tranche de circuit intégré.

Le brevet des Etats-Unis d'Amérique n° 4757255 décrit un système de contrôle automatique de circuits intégrés permettant d'opérer dans une atmosphère d'azote sec pour éviter la condensation et le givrage à basse température. Mais le dispositif de refroidissement de ce système est assuré par circulation de méthanol froid, n'assurant au mieux qu'une température de -60°C et provenant d'un circuit extérieur relié au système à l'aide de tubes souples d'amenée qui présentent l'inconvénient de durcir à ces températures.

Le but de l'invention est de remédier à ces limitations en proposant un système à dispositif de refroidissement fonctionnant à plus basse température, de façon automatique, en vue notamment d'un contrôle industriel efficace de la qualité des circuits intégrés réalisés à partir des matériaux supraconducteurs actuels.

A cet effet, l'invention concerne un système de contrôle automatique de circuits intégrés caractérisé en ce qu'il comprend également un dispositif de refroidissement, interne au système, comprenant lui-même un réservoir de fluide réfrigérant muni d'un couvercle et d'un tube se prolongeant dans ledit fluide pour conduire celui-ci vers une cavité de refroidissement interne au porte-échantillon et munie d'un dispositif d'évacuation du fluide hors de ladite cavité.

La structure ainsi proposée est avantageuse à plusieurs titres. La solution technique qui consiste à prévoir un dispositif de refroidissement interne au système évite le problème mécanique mentionné plus haut, et est de mise en oeuvre simple, compatible avec la mise en place aussi bien des dispositifs de balayage du volume interne de la chambre avec légère surpression que des moyens de fixation de la tranche à tester sur son support, en général par application de vide sur la face arrière de ladite tranche. Les moyens adoptés pour cette injection de fluide réfrigérant en vue du refroidissement du porte-échantillon sont de nature à laisser s'effectuer librement les divers mouvements de translation et/ou de rotation de l'ensemble mécanique. Par ailleurs, l'utilisation d'un porte-échantillon creux pour l'injection de petites quantités de fluide réfrigérant liquide et sa vaporisation, en vue de la réfrigération préalable aux tests, permet d'opérer de tels refroidissements de façon simple et rapide, ce qui est utile si l'on veut effectuer, sur les tranches à tester, des mesures à différentes températures sans perdre de temps.

Les particularités de l'invention apparaîtront maintenant de façon plus détaillée dans la description qui suit et sur la figure annexée, donnée à titre d'exemple non limitatif de réalisation du système selon l'invention.

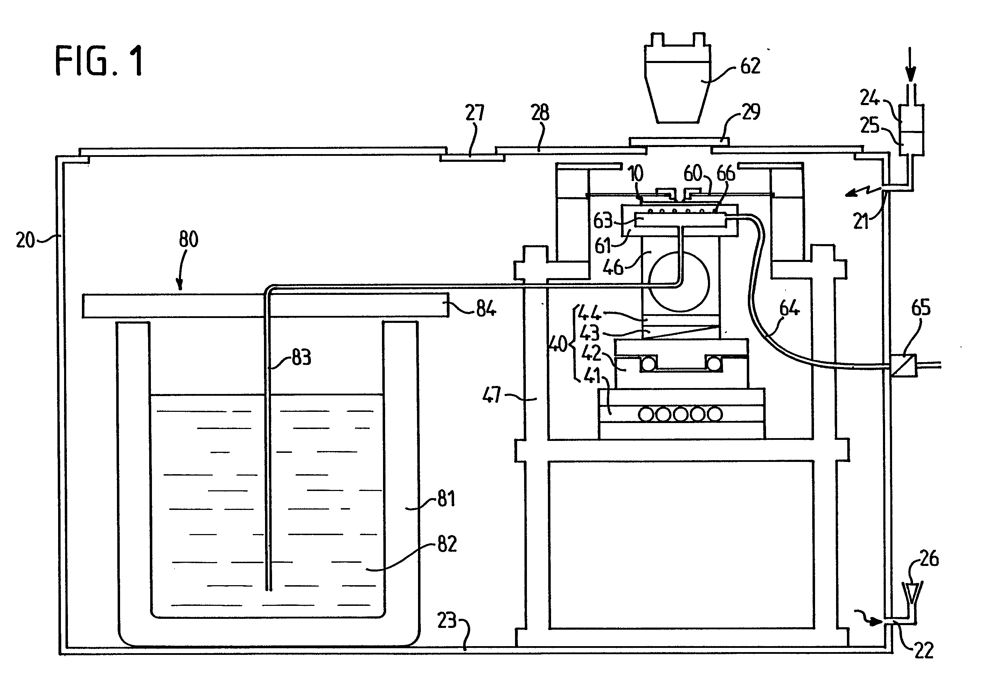

Dans le mode de réalisation préférentiel représenté sur la figure 1, le système selon l'invention comprend tout d'abord une chambre étanche 20 qui est balayée en permanence par un flux d'azote sec (ou d'un autre gaz sec permettant d'éviter la condensation ou le givrage). L'introduction du gaz est réalisée à l'aide d'orifices d'admission 21 situés dans le cas présent à la partie supérieure de la chambre 20, à proximité de la tranche de circuit intégré 10 en cours de test, et son extraction à l'aide d'orifices d'évacuation 22 situés en général à la partie inférieure de la chambre 20, près du fond 23. Un seul des orifices d'admission 21 et un seul des orifices d'évacuation 22 ont été représentés, mais ils sont en général plus nombreux et répartis autour de la chambre. Le gaz, ici l'azote, utilisé pour ce balayage peut être préalablement asséché, au cours de la traversée d'un dispositif de séchage tel qu'un piège à azote liquide 24, puis réchauffé à l'aide d'un dispositif à résistances 25. Une légère surpression est maintenue dans la chambre 20 pour éviter toute infiltration d'air humide dans celle-ci, et le contrôle de cette surpression, de l'ordre de 20 millibars par exemple, est assuré par un limiteur de pression 26 raccordé sur les orifices d'évacuation 22.

La paroi supérieure 27 de la chambre 20 est surmontée d'un couvercle articulé 28 muni lui-même d'un hublot 29. Le couvercle 28 permet l'accès à l'échantillon à tester, et le hublot 29 permet d'effectuer, avec un microscope 62, un alignement entre la tranche 10 à tester et une carte à pointes de liaison électrique avec ladite tranche.

La tranche 10 à tester est supportée par un porte-échantillon 61 situé à l'intérieur de la chambre 20, dans sa partie supérieure. Ce porte-échantillon 61 est à son tour porté par un ensemble mécanique 40 comprenant lui-même un empilement de tables 41, 42, 43, 44 à mouvement automatique motorisé de façon tout à fait classique. Ces tables 41 à 44 autorisent respectivement des déplacements X, Y, Z, $\theta$ de la tranche 10, selon l'un ou l'autre des deux axes horizontaux, et/ou selon un axe vertical transversal aux précédents, et/ou en rotation. Le porte-échantillon 61, de déformation nulle ou négligeable avec la température, est fixé sur ledit ensemble de tables par l'intermédiaire d'une cale thermiquement isolante 46 pour éviter de refroidir les tables. Les tables de déplacement sont de préférence mises en place sur un statif rigide 47 solidaire de la chambre 20.

A côté de cet ensemble mécanique 40, un dispositif 80 de refroidissement du porte-échantillon 61 est prévu. Ce dispositif 80 interne au système comprend un réservoir isolant 81, rempli par exemple d'azote liquide 82, ou de tout autre fluide réfrigérant. Dans ce réservoir vient tremper un tube 83 destiné à élever l'azote (ou le fluide liquide) vers le porte-échantillon 61. Ce tube est réalisé en un matériau à faible conductibilité thermique. Un couvercle isolant 84 solidaire du tube 83 interdit ou limite considérablement les pertes d'azote (de fluide) liquide par convection. Le réservoir 81 peut, éventuellement, être alimenté de l'extérieur. Le porte-échantillon 61 est creux et sa cavité interne 63 est reliée au réservoir 81 d'azote (de fluide) liquide par le tube 83. Ladite cavité 63 peut en outre être munie d'un système de chicanes, ou remplie par exemple de tournure de cuivre, en vue de favoriser la vaporisation de l'azote (du fluide) liquide. L'azote (ou le fluide) gazeux ainsi formé est réchauffé à une température voisine de la température ambiante par passage dans un réchauffeur constitué d'un tube en contact avec une résistance électrique et est évacué par l'intermédiaire d'un tuyau souple 64 et d'une électro-vanne 65.

Le fonctionnement du système ainsi décrit est le suivant. Après mise en place, par ouverture du couvercle 28, de la tranche 10 à tester et de la carte à pointes 60 qui lui est reliée, le volume interne de la chambre est purgé de tout air humide par envoi d'un flux important d'azote (ou du gaz utilisé), asséché et chauffé pour augmenter sa capacité de transport de vapeur d'eau. Simultanément, le porte-échantillon 61, équipé d'une résistance chauffante 66, est lui-même porté à une température d'environ 50° C par exemple, pour bien l'assécher lui-aussi.

On réduit alors le flux d'azote (de gaz) à une valeur nettement plus faible, puis l'on refroidit le porte-échantillon 61 à la température de test voulue en lui envoyant par le tube 83 des salves d'azote (de fluide) liquide. Le simple fait d'ouvrir l'électrovanne 65 sur l'extérieur fait monter une colonne d'azote (de fluide) liquide 82 du réservoir 81 vers la cavité 63 du porte-échantillon 61, où cet azote (ce fluide) se vaporise en refroidissant ledit porte-échantillon. Cette alimentation est avantageusement accélérée par pompage au niveau de l'électrovanne 65.

On peut alors procéder aux tests voulus, tout en continuant à réguler la température du porte-échantillon 61. Cette régulation de température est effectuée en mesurant la température du porte-échantillon 61, en la comparant à une température de consigne, et en agissant alors sur l'électrovanne 65 pour réduire l'écart de température à une valeur négligeable. Il existe sur le marché de nombreux régulateurs par tout ou rien, convenant pour cette application. Ce type de régulation par fluide présente l'avantage de n'induire aucun parasite électrique au niveau de la tranche 10 à tester.

Une fois les tests terminés, on réchauffe le porte-échantillon 61 jusqu'à la température ambiante et l'on peut alors ouvrir le couvercle 28 pour récupérer la tranche 10 testée, sans risque de givrage.

Tout le cycle d'opérations a été décrit en détaillant chaque phase, mais en général ces opérations sont enchaînées de façon automatique, sous la conduite d'un microprocesseur ou d'un automate.

## Revendications

1. Système de contrôle automatique de circuits intégrés en tranche comprenant :

(a) une chambre équipée d'au moins un orifice d'admission pour l'introduction d'un gaz sec inerte et d'au moins un orifice d'évacuation, des dispositifs d'une part de séchage et chauffage et d'autre part de contrôle de la surpression dans la chambre étant éventuellement adjoints auxdits orifices d'admission et d'évacuation respectivement ;

(b) dans ladite chambre, un porte-échantillon de support desdits circuits intégrés ;

(c) un ensemble mécanique pour la commande des déplacements relatifs du porte-échantillon et d'une carte de test des circuits intégrés ;
caractérisé en ce qu'il comprend également un dispositif de refroidissement, interne au système, comprenant lui-même un réservoir de fluide réfrigérant muni d'un couvercle et d'un tube se prolongeant dans ledit fluide pour conduire celui-ci vers une cavité de refroidissement interne au porte-échantillon et munie d'un dispositif d'évacuation du fluide hors de ladite cavité.

2. Système selon la revendication 1, caractérisé en ce que ledit porte-échantillon est solidaire dudit ensemble mécanique par l'intermédiaire d'une cale thermiquement isolante.

3. Système selon l'une des revendications 1 et 2, caractérisé en ce qu'il comprend également un microprocesseur ou un automate de gestion des séquences de balayage de gaz sec et de commande de la température du porte-échantillon.

4. Procédé de mise en oeuvre du système selon l'une des revendications 1 à 3, caractérisé en ce qu'il comprend les opérations suivantes :

(a) mise en place de la tranche à tester et de la carte de test qui lui est reliée ;

(b) assèchement de l'atmosphère interne de la chambre et du porte-échantillon par circulation du gaz sec et par chauffage ;

(c) refroidissement du porte-échantillon par vaporisation de fluide réfrigérant à l'intérieur de celui-ci ;

(d) exécution des tests sur la tranche à tester, avec régulation de la température du porte-échantillon pendant lesdits tests ;

(e) réchauffement du porte-échantillon et extraction de la tranche testée.

FIG. 1

EP 0 349 042 A2

PHF 88-558